# EUROPEAN PATENT SPECIFICATION

(11) **EP 0 616 452 B1**
(45) Date of publication and mention of the grant of the patent: **31.03.1999**
(21) Application number: 92117468.6
(22) Date of filing: 13.10.1992
(51) Int. Cl.: H04L 27/00, H03H 17/02

(54) **Hierarchical multistage digital FDM demultiplexer**
Hierarchisch aufgebauter mehrstufiger digitaler FDM-Demultiplexer
Démultiplexeur numérique hiérarchique à étages multiples pour signaux FDM

(43) Date of publication of application: 21.09.1994
(73) Proprietor: ROBERT BOSCH GMBH, 70442 Stuttgart (DE)
(72) Inventor: Auer, Erich, Dr.Ing., W-7122 Besigheim 3 (DE); Battenschlag, Peter, Dipl.-Ing., W-7012 Fellbach (DE)

(56) References cited:
- EP-A- 0 308 649
- WO-A-87/06075
- GB-A- 2 205 462

## Description

The invention relates to a method for digital FDM demultiplexing using digital filter banks in accordance to the preamble of claim 1.

Digital filter banks are known from the publications " A Modular Multistage Approach to Digital FDM Demultiplexing for Mobile SCPC Satellite Communications" by Göckler in the International Journal of Satellite Communications, Volume 6, pages 283 - 288 (1988) and "Simulation of an Onboard Hierarchical Multistage Digital FDM Demultiplexer for Mobile SCPC Satellite Communications" by Helmut Eyssele and Heinz Göckler in the International Journal of Satellite Communications, Volume 8, pages 79 - 93, 1990.

Depending on the filter characteristic and the word length of the signal representation digital filter banks become very complex leading to large chip area requirements and high power consumption. Particularly in satellite communications power and space consumption are crucial criteria in assessing the usefulness of a concept. In this application minimum power consumption was the design goal along with the requirement to fit the complete design into 35000 gates. Although the specifications of the European Space Agency required the design to run at just 320 kHz the chip is actually capable of running at 20 MHz system clock speed.

EP 308 649 discloses a digital filter tree composed of a plurality of digital filter banks arranged in a tree structure where each node of each stage has two successor filter banks connected. All filter banks are identical. The frequency multiplex signal input to the first stage is real valued and its sampling rate is decimated by a factor of two.

This invention aims at a method for digital FDM demultiplexing that requires fewer computational elements and leads to a reduced chip area and a reduced power consumption.

The solution is the method as characterized in the claims.

The description of the invention is supported by the figures.

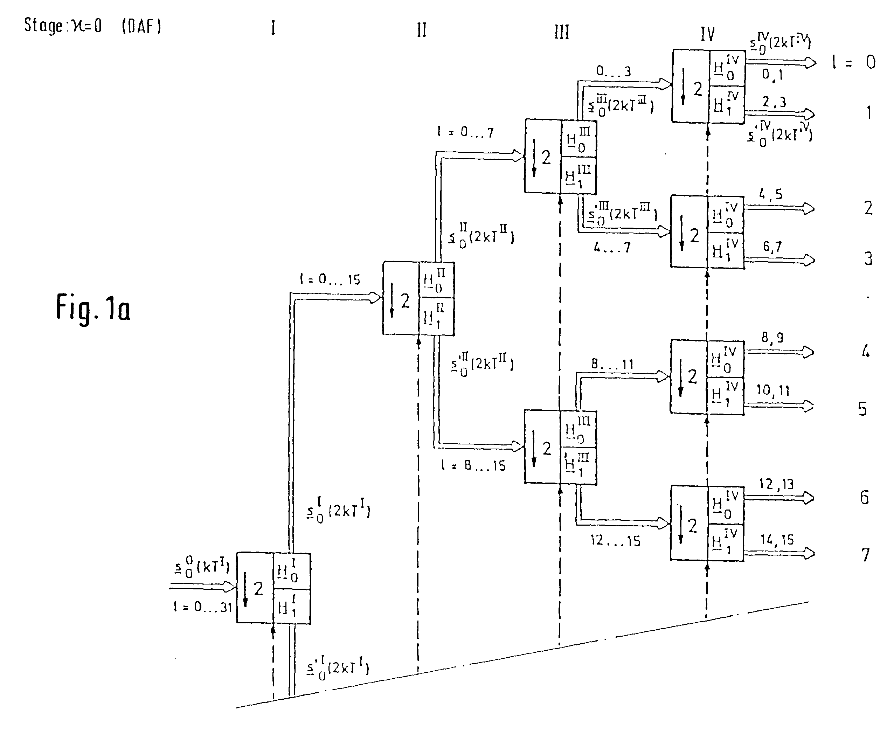

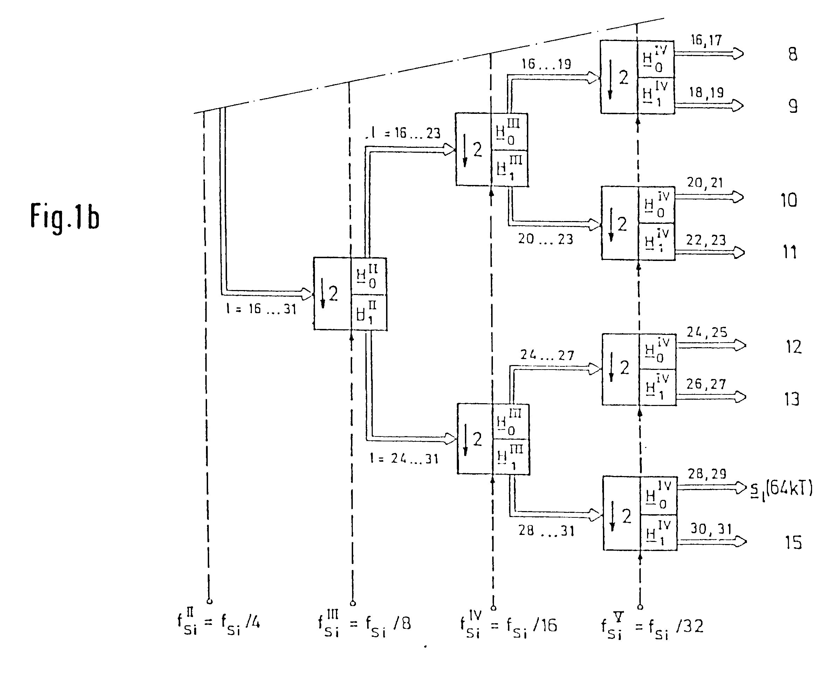

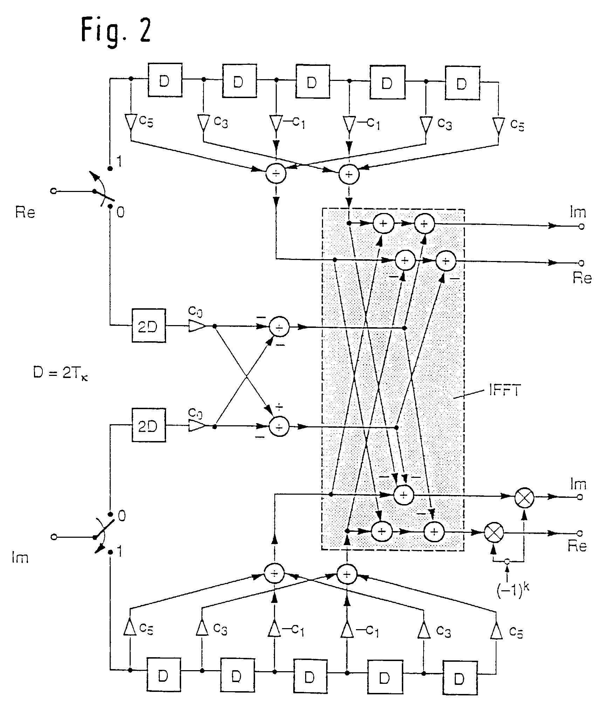

First the HMM-Cells (same as filter bank) are described as shown in the block diagram of Fig. 1 and in greater detail in Fig. 2.

The purpose of a single HMM-Cell is to demultiplex a complex-valued FDM-Signal into two subbands with the effect that the number of subband doubles and their respective sampling rate and the bandwidth carried by a signal is decimated by two.

The gate count in the ASIC can be significantly reduced for the signal processing elements if only a single HMM-Cell is deployed in each stage of the tree. This concept leads to a time-multiplex HMM structure. Multiplexed data processing is being carried out for real and imaginary parts of the signal and for the signals associated with the different subbands. Multiplexing is confined to one stage in the tree structure. According to this concept 4 HMM-Cells are implemented in the ASIC. The register elements are replaced by delay lines (which implement a shift register) and matched to the number of subbands to be processed. Fig. 2 illustrates the basic functions carried out in a HMM-Cell. Each HMM-structure consists of two decimation filters that decompose the input signal into the two subbands. The decimation filters are implemented as a low-pass and a band-pass filter that is followed by a down converter. The signal flow diagram in Fig. 2 shows that both filters consist of identical FIR filter structures with coefficients only differing in sign. This property is the key to the sequential implementation of the filter bank.

Computations in the HMM-Cell core, designated as IFFT in Fig. 2, are subdivided into 4 basic summations. This is necessary for a single output port to be operated multiplexed for two different output signals where one signal (the high-pass signal) still needs to be frequency shifted, i.e. multiplied with (-1)^{k}, where k denotes the discrete time variable at the filter output sampling rate.

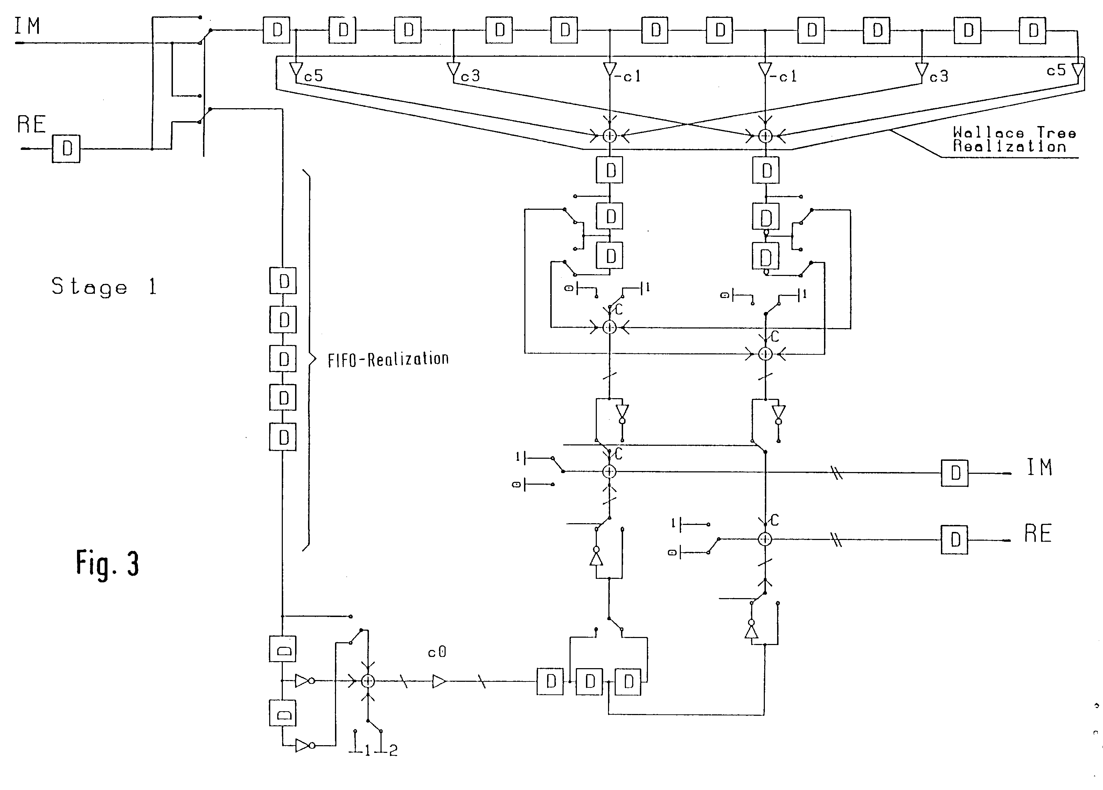

The adder of the basic FIR filter structure outputs the operands for subsequent summations. The operands must be intermediately stored for sequential processing, as shown in Fig. 3. Multiplication with -1, depicted as minus sign at the adder inputs, are carried out through data inversion and setting the carry bit at the LSB position of the following adder to 1.

The following table lists the output operations and the data input in a four step sequence.

| Computation Cycle | Input to delay line for even coefficients | Input to delay line for odd coefficients | Output generated |
|---|---|---|---|
| 0 | Re {s(n-1)} | Im {s(n)} | Upper band where (-1)^{k} evaluates to 1 |
| 1 | Im {s(n+1)} | Re {s(n)} | Lower band |
| 2 | Re {s(n+1)} | Re {s(n+2)} | Upper band where (-1)^{k} evaluates to -1 |
| 3 | Im {s(n+3)} | Im {s(n+2)} | Lower band |

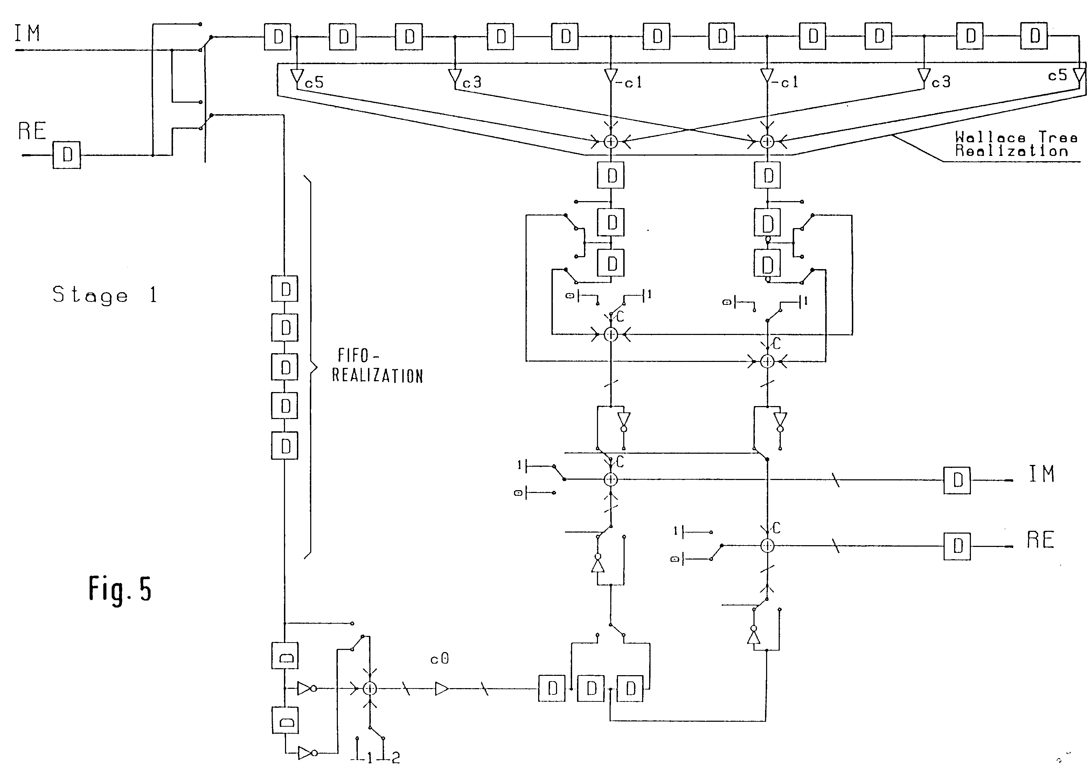

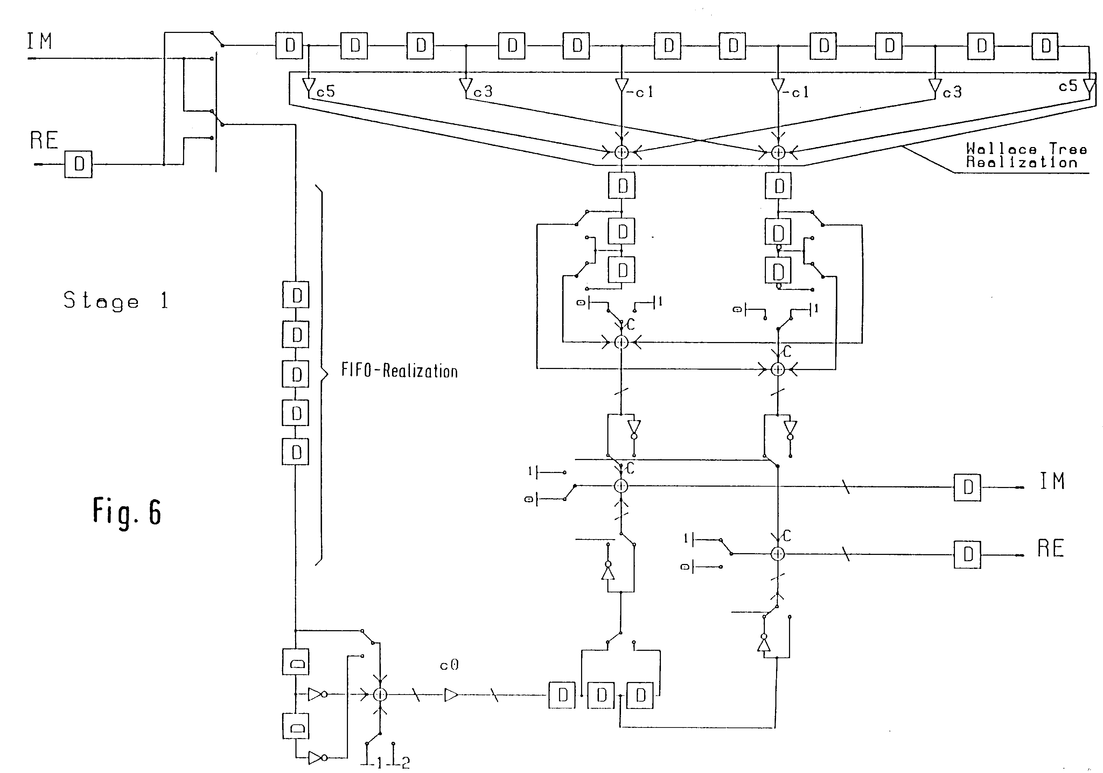

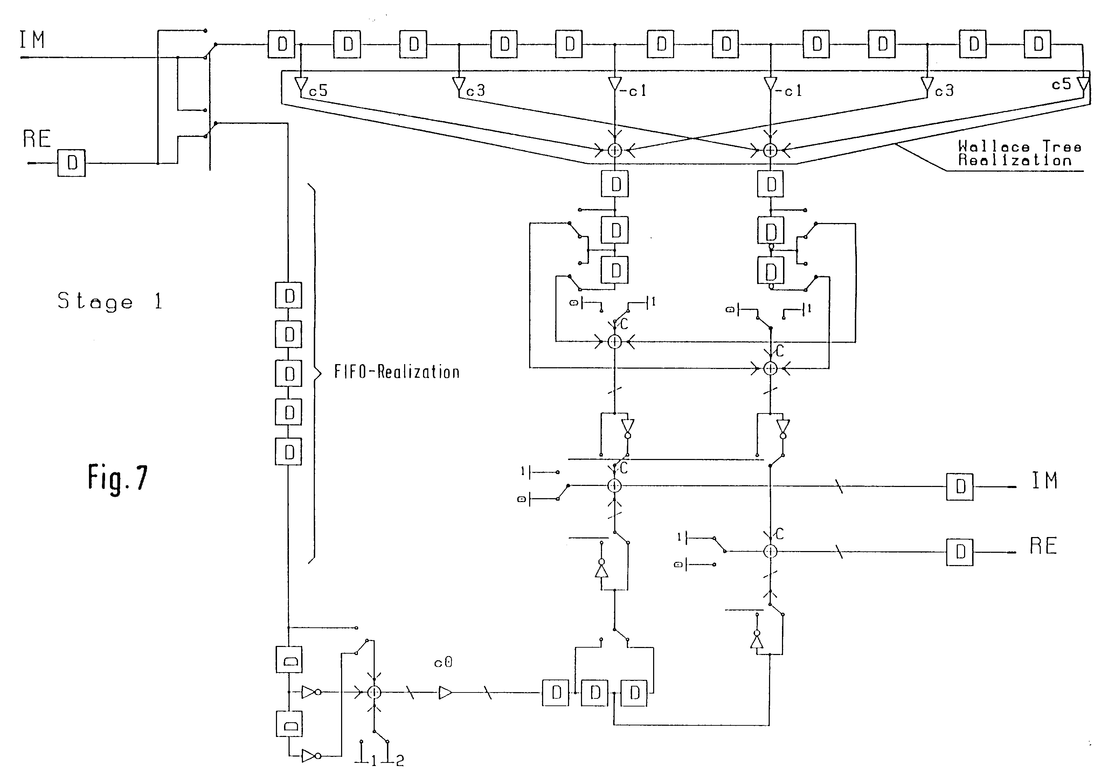

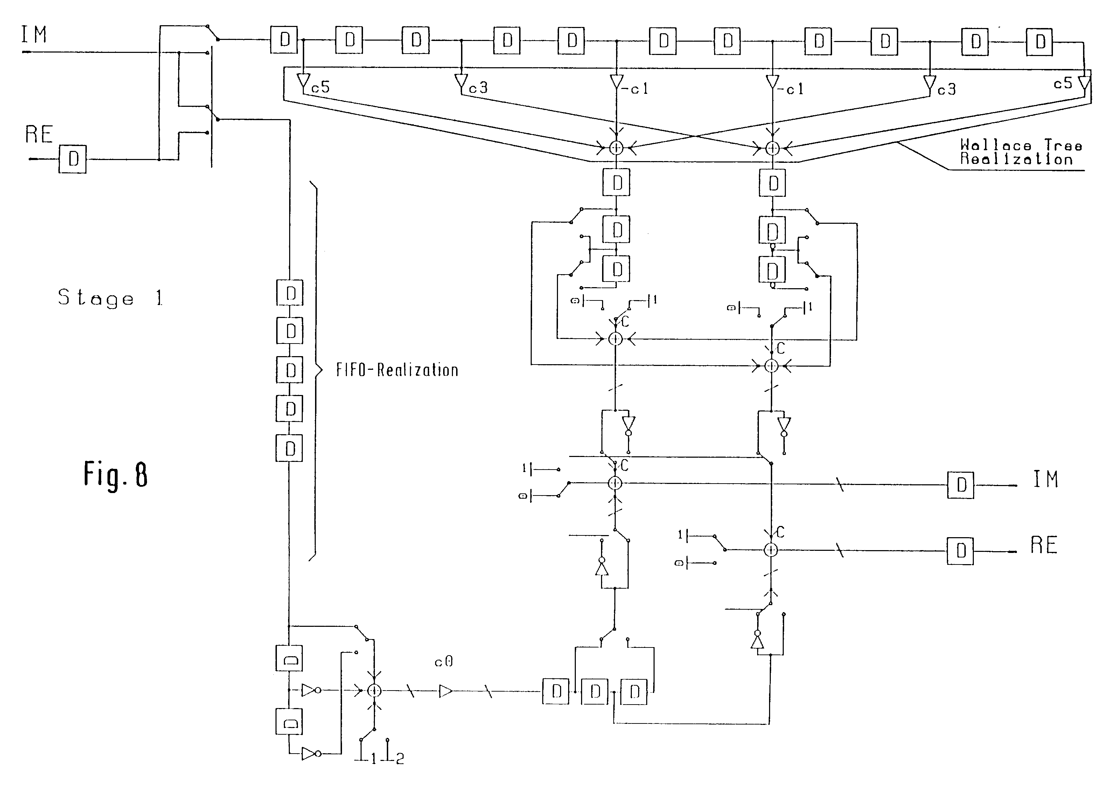

For each cycle the switches depicted in the filter core in Fig. 3 are positioned such that the arithmetic operation associated with this cycle is carried out. Fig. 5 through Fig. 8 illustrate the switch positions for the four computation cycles.

As with every decimation filter, the HMM-Cell needs two new input samples to enable computation of a new output sample. This behaviour can also be seen in Fig. 2 where an input switch distributes data of one type to registers that operate at half of the sampling frequency. In Fig. 3 the same behaviour is obtained by using two registers instead of one that both run on the input sampling rate, but are being fed by real and imaginary data part in sequence. At the same time the computations of the filter must take place each time a data sample is fed into the filter structure.

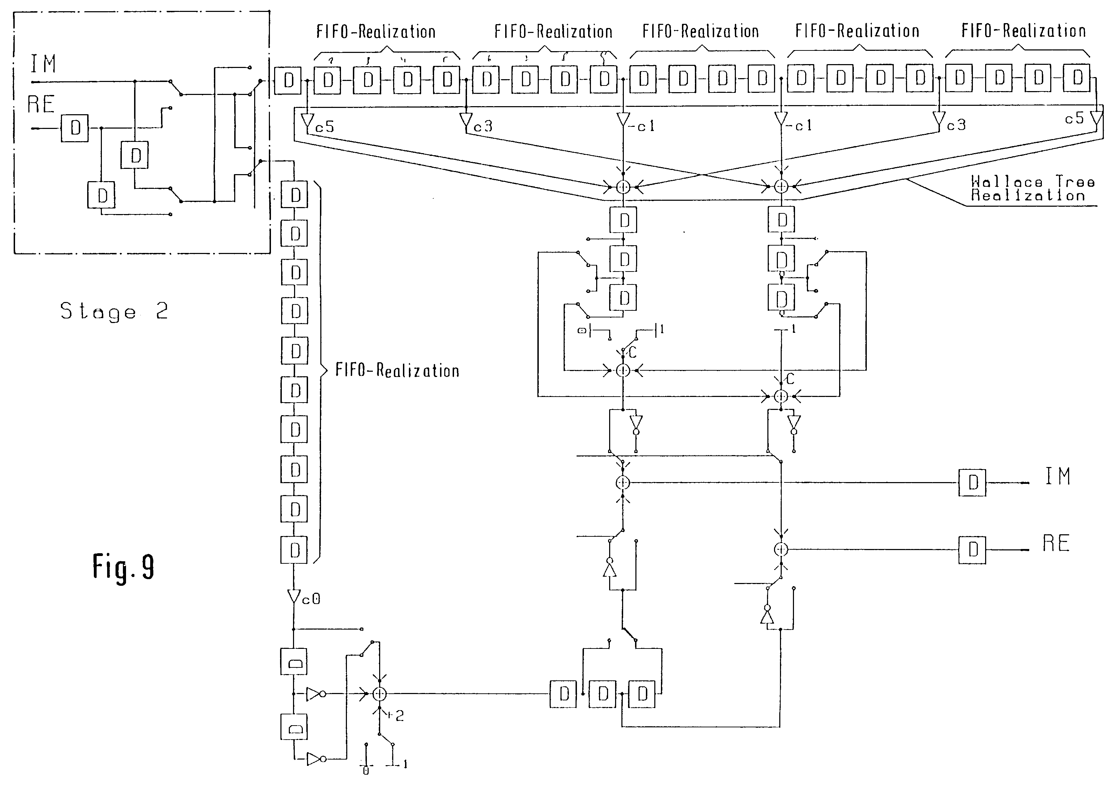

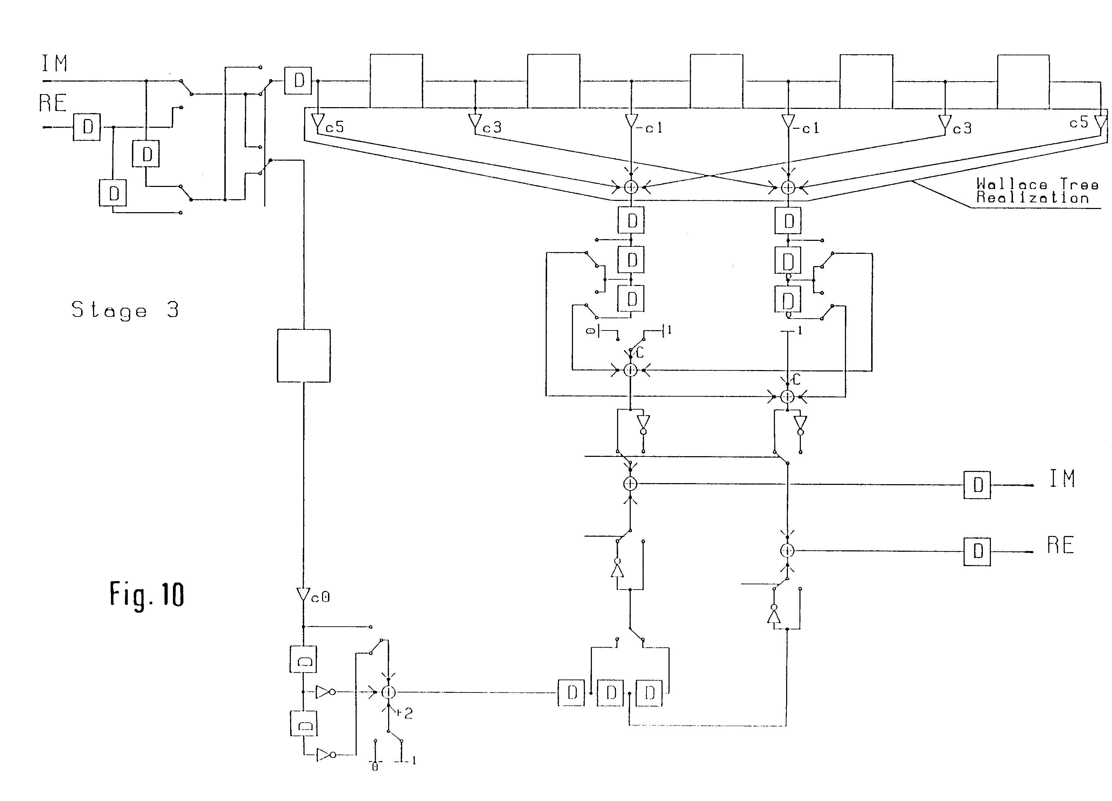

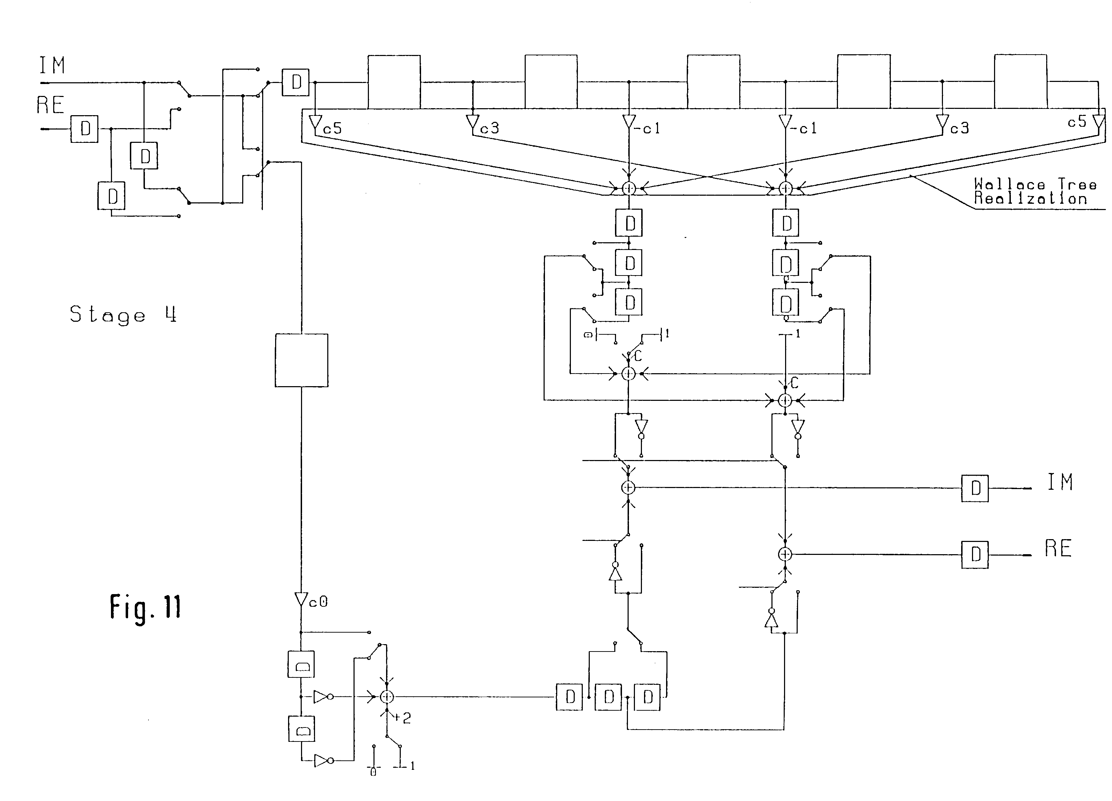

HMM-Cells placed at lower hierarchy than the first are fed with a time-multiplexed signal at the input. Those cells still require the presence of two complex-valued samples of the same subband in its delay lines before computations can commence. This new situation is obviated by a modified input switch circuit at the filter input, illustrated in Fig. 9, 10, and 11. This input switch uses the fact that it is irrelevant which delay line is fed with the first or the second data sample. As can be seen in Fig. 9 the input switch circuit consists of three registers and two pairs of switches. The input switches alternate with every clock cycle while the output switches in the second HMM stage alternate only every second cycle, in the third HMM stage only every fourth cycle and so on. This has the effect that the spacing between samples of the same subband type can be compensated in a single delay line which is the one that feeds the coefficient c0.

The arithmetic section of the filter determines the maximum speed of the design. Multiplication are carried out using CSD-Code coefficient representation along with a Wallace-Tree structure. Each HMM-Cell consists of two separate Wallace-Trees as shown in Fig. 3.

By placing a register after both Wallace Trees only the propagation delay of the Wallace-Tree determines the maximum clock frequency.

One main objective of the FDM Demultiplexer design is to minimize power consumption. As shown in Fig. 9 for a HMM-Cell of the second stage the registers of the filter of Fig. 3 are replaced by twice the amount of registers. Instead of a line of registers a first-in first-out (FIFO) memory is devised that uses pointers for its read and write operations, effectively preventing data toggle in all but one FIFO register per clock cycle (which is the one that is updated). All delay lines with more than 2 elements are implemented as FIFO memories.

## Claims

1. A method for digital FDM demultiplexing by a hierarchical multistage digital FDM Demultiplexer wherein a plurality of digital filter banks is used consisting of HMM-Cells which are arranged one behind the other to branch out in successive steps into a tree structure in accordance with the Hierarchical Multistage Method (HMM) where, starting with the first stage, each HMM-Cell is to demultiplex a respective complex valued FDM-Signal into two subbands with the sampling rate being reduced each time, characterized by the following items:
• in each HMM-Cell by itself multiplexed data processing is carried out for real and imaginary signal parts and for data of different subbands,
• at the input of each HMM-Cell a switching circuit alternately feeds the odd and the even tap delay line of the HMM-Cell with data originating from successive time instants respectively,
• from one hierarchy level to the next inside a HMM-Cell the number of delay elements between two coefficient taps double,
• each of the second and following HMM-Cells is fed with a multiplex signal carrying a multitude of subbands.

2. Method according to claim 1, characterized in that all delay lines of the HMM-Cells with more than two delay elements are implemented using a FIFO memory.

## Patentansprüche

1. Verfahren zum digitalen FDM-Demultiplexieren durch einen hierarchisch aufgebauten, mehrstufigen digitalen FDM-Demultiplexer, in dem viele verschiedene digitale Filterbänke benutzt werden, bestehend aus HMM-Zellen, die hintereinander angeordnet sind zum Auszweigen in aufeinanderfolgenden Stufen zu einer Baumstruktur entsprechend der "Hierarchical Multistage Method (HMM)", wobei beginnend bei der ersten Stufe jede HMM-Zelle ein jeweiliges komplexwertiges FDM-Signal in zwei Subbänder mit jedesmal reduzierter Abtastfrequenz demultiplexiert, dadurch gekennzeichnet, daß:
• in jeder HMM-Zelle selbst Verarbeitung multiplexierter Daten erfolgt für reale und imaginäre Signalteile und für Daten von verschiedenen Subbändern;
• am Eingang jeder HMM-Zelle eine Schaltschaltung abwechselnd die ungerade und gerade Zapf-Verzögerungsstrecke der HMM-Zelle mit Daten speist, die von jeweils aufeinanderfolgenden Zeitpunkten stammen;
• von jeder Hierarchieebene zur nächsten in einer HMM-Zelle die Zahl der Verzögerungselemente zwischen zwei Koeffizienten-Zapfstellen sich verdoppelt;
• jede der zweiten und folgenden HMM-Zellen mit einem viele Subbänder tragenden Multiplexsignal gespeist wird.

2. Verfahren nach Anspruch 1, dadurch gekennzeichnet, daß alle Verzögerungsstrecken der HMM-Zellen mit mehr als zwei Verzögerungselementen unter Verwendung eines FIFO-Speichers implementiert werden.
(Beschriftung der Figuren:)
Stage = Stufe
Realization = Realisierung

## Revendications

1. Procédé de démultiplexage numérique FDM par un démultiplexeur FDM numérique hiérarchique à multiples étages, selon lequel :
on utilise plusieurs ensembles de filtres numériques formés de cellules (HMM) réparties l'une derrière l'autre selon des branches dans des étapes successives suivant une structure arborescente selon le procédé hiérarchique d'étages multiples (procédé HMM) selon lequel, en commençant par le premier étage, chaque cellule (HMM) doit démultiplexer un signal FDM de valeur complexe respective, pour donner deux sous-bandes, le taux d'échantillonnage étant réduit à chaque fois,
caractérisé par les éléments suivants :
- dans chaque cellule HMM, on effectue un multiplexage de données pour la partie réelle et la partie imaginaire du signal et pour obtenir des données de sous-bande différentes,
- à l'entrée de chaque cellule HMM un commutateur alimente en alternance la borne impaire et la borne paire de la ligne à retard de la cellule HMM pour leur fournir des données provenant d'instants successifs respectifs,
- d'un niveau hiérarchique au suivant à l'intérieur d'une cellule HMM, le nombre d'éléments de retard entre deux bornes de coefficient est doublé,
- chacune des secondes cellules HMM et des cellules suivantes reçoit un signal multiplexé contenant une multitude de sous-bandes.

2. Procédé selon la revendication 1,
caractérisé en ce que
toutes les lignes à retard des cellules HMM ayant plus de deux éléments de retard, sont réalisées avec une mémoire FIFO.
